# EUROPÄISCHE PATENTSCHRIFT

(11) **EP 2 445 849 B1**
(45) Veröffentlichungstag und Bekanntmachung des Hinweises auf die Patenterteilung: **05.08.2015**
(21) Anmeldenummer: 10726966.4
(22) Anmeldetag: 23.06.2010
(51) Int. Cl.: C04B 35/491, C04B 35/493, C01G 23/00, C01G 25/00, C04B 35/626, H01L 41/187, H01L 41/273

(54) **KERAMIKMATERIAL UND VERFAHREN ZUR HERSTELLUNG DES KERAMIKMATERIALS**
CERAMIC MATERIAL AND METHOD FOR PRODUCING THE SAME
MATÉRIAU CÉRAMIQUE ET PROCÉDÉ DE FABRICATION DUDIT MATÉRIAU CÉRAMIQUE

(30) Priorität: 26.06.2009 DE 102009030710
(43) Veröffentlichungstag der Anmeldung: 02.05.2012
(73) Patentinhaber: Epcos AG, 81669 München (DE)
(72) Erfinder: GRÜNBICHLER, Hermann, A-8503 St. Josef (AT); SCHWEINZGER, Manfred, A-8541 Schwanberg (AT); MEAD, Christl Lisa, A-8543 St. Martin i.S. (AT); NAGY, Aniko, A-8530 Deutschlandsberg (AT)
(74) Vertreter: Epping - Hermann - Fischer
(86) Internationale Anmeldenummer: PCT/EP2010/058940
(87) Internationale Veröffentlichungsnummer: WO 2010/149716

(56) Entgegenhaltungen:
- WO-A1-2006/063784
- DE-C1- 4 314 911
- US-A- 5 164 882
- US-A- 5 246 610
- BANNO H ET AL: "Preparation and properties of PZT/PbTiO3 ceramic composite", FERROELECTRICS, 1996. ISAF '96., PROCEEDINGS OF THE TENTH IEEE INTERNA TIONAL SYMPOSIUM ON APPLICATIONS OF EAST BRUNSWICK, NJ, USA 18-21 AUG. 1996, NEW YORK, NY, USA,IEEE, US, vol. 1, 18 August 1996 (1996-08-18), pages 523-526, XP010228215, DOI: 10.1109/ISAF.1996.602804 ISBN: 978-0-7803-3355-0

## Beschreibung

Es wird ein Keramikmaterial nach dem Hauptanspruch 1 angegeben.

In der DE 43 14 911 C1 wird ein Verfahren zur Herstellung einer PZT-Keramik der allgemeinen Formel Pb(ZrₓTi₁₋ₓ)O₃ angegeben.

Die WO 2006/063784 A1 betrifft feinteilige Zirkoniumtitanate beziehungsweise Bleizirkonattitanate sowie ein Verfahren zu deren Herstellung.

In der US 5,164,882 wird ein keramischer Kondensator mit einer dielektrischen keramische Masse der allgemeinen Formel (Pb₁₋ₓAeₓ) (Zr_{1-y}Ti_{y})O₃ beschrieben.

Banno et al. (Banno H. et al.: Preparation and Properties of PZT/PbTi03 Ceramic Composite, Applications of Ferroelectrics, 1996. ISAF '96., pp. 523-526) und US 5 246 610 A beschreiben zweiphasige Keramiken bestehend aus Pb(Zr,Ti)O₃ und PbTiO₃.

Ein weit verbreitetes Problem bei der Herstellung von piezoelektrischen Keramikmaterialien ist es, das Material so herzustellen, dass gewünschte, je nach Bedarf unterschiedliche piezoelektrische Parameter erhalten werden.

Diese piezoelektrischen Parameter sind eng mit dem Kornwachstum des Keramikmaterials während des Sinterprozesses verbunden. Man hat bisher versucht das Kornwachstum auf zwei unterschiedliche Arten zu fördern.

Zum einen durch das Sintern bei sehr hohen Temperaturen, was den Nachteil hat, dass für den Fall, dass das Keramikmaterial gemeinsam mit beispielsweise Innenelektroden gesintert wird, diese aus einem Material gefertigt sein müssen, welches erst bei sehr hohen Temperaturen schmilzt. Diese Materialien sind beispielsweise Edelmetalle, welche recht teuer sind. Ein weiterer Nachteil dieser Variante ist, dass es durch die hohe Temperatur zu deutlichen PbO-Verlusten im Keramikmaterial kommt, wodurch sich die Zusammensetzung des Keramikmaterials in schwer kontrollierbarer Weise verändert.

Zum anderen wurden dem Keramikmaterial Sinterhilfsmittel wie beispielsweise Silikate oder Borate zugesetzt. Diese Vorgehensweise hat den Nachteil, dass die Sinterhilfsmittel in das Keramikmaterial mit eingebaut wurden. Somit wurde zwar das Kornwachstum an sich gefördert, aber durch den Einbau der störenden Fremdstoffe musste wieder eine Verschlechterung der piezoelektrischen Parameter in Kauf genommen werden. Ein weiterer Nachteil ist die unerwünschte Reaktion des Sinterhilfsmittels mit dem Elektrodenmaterial, für den Fall, dass das Keramikmaterial zusammen mit den Innenelektroden gesintert wird.

Eine Aufgabe von Ausführungsformen der Erfindung besteht darin, ein Keramikmaterial bereitzustellen, welches über verbesserte piezoelektrische Eigenschaften verfügt.

Bei den piezoelektrischen Eigenschaften kann es sich beispielsweise um die Dielektrizitätskonstante εᵣ, die piezoelektrische Ladungskonstante d₃₃ oder den Kopplungsfaktor k handeln. Die relative Dielektrizitätskonstante εᵣ ist das Verhältnis aus der absoluten Permittivität des Keramikmaterials und der Permitivität im Vakuum, wobei die absolute Permitivität ein Maß für die Polarisierbarkeit im elektrischen Feld darstellt. Die Wirksamkeit des Piezoeffektes wird durch die piezoelektrische Ladungskonstante dij gekennzeichnet, die das Verhältnis der erzeugten Ladungsdichte zur mechanischen Verformung darstellt. Die Richtungsabhängigkeit des Parameters wird durch die entsprechenden Indizes angegeben. Der Index i der piezoelektrischen Ladungskonstanten gibt die Richtung des elektrischen Feldes an, der Index j die Richtung der Deformation, mit der der Kristall auf das Feld reagiert. Hierbei steht eine 1 für die x-Richtung, 2 für die y-Richtung und 3 für die z-Richtung. Die piezoelektrische Ladungskonstante d₃₃ bezeichnet somit das longitudinale Dehnungsverhalten in Richtung der z-Achse. Der Kopplungsfaktor k ist ein Maß für den Grad des piezoelektrischen Effekts. Er beschreibt das Vermögen eines piezoelektrischen Materials, aufgenommene elektrische Energie in mechanische Energie umzuwandeln und umgekehrt. Hierbei steht k₃₃ für den Kopplungsfaktor der Longitudinalschwingung. Beim Longitudinal-Effekt ist die Polarachse des Kristalls kolinear zur Deformationsrichtung.

Die Aufgabe wird durch ein Keramikmaterial nach dem Anspruch 1 gelöst. Weitere Ausführungsformen des Keramikmaterials, sowie ein Herstellungsverfahren für das Keramikmaterial sind Gegenstand weiterer Patentansprüche.

In einer Ausführungsform kann das Keramikmaterial durch die folgende allgemeine Formel beschrieben werden:

Pb_{1-(m/2)x}M^{m}ₓ(Zr_{1-y}Ti_{y})O₃ + a-zPbTiO₃

wobei M für mindestens ein Element steht ausgewählt aus: Nd, La, Ba, Sr, Sb, Bi, K, Na, und
wobei gilt: 0 ≤ x ≤ 0,1; 0,3 ≤ y ≤ 0,7; 0 ≤ z ≤ y; 0 < (a-z) ≤ 0,03 und m entsprechend der Wertigkeit des jeweiligen Metalls M den Wert +1, +2 oder +3 hat.

Bei dem Keramikmaterial handelt es sich je nach Abhängigkeit von den Parametern a und z um ein einphasiges oder zweiphasiges System. Sowohl in dem einphasigen System wie auch in dem zweiphasigen System liegen die eine bzw. die beiden Phasen jeweils in einer Perowskitstruktur vor. Das Perowskitgitter kann durch die allgemeine Formel ABO₃ beschrieben werden. Hierbei sind die Pb-Ionen, sowie falls vorhanden auch die M-Ionen auf den A-Plätzen des Gitters angeordnet. Die Zr-Ionen sowie die Ti-Ionen besetzen die B-Plätze des Ionengitters.

Hierbei nimmt m für die Elemente Nd, La, Sb und Bi einen Wert von +3 an, für die Elemente Ba und Sr den Wert +2 und für die beiden Elemente K und Na den Wert +1.

Ein Keramikmaterial dieser Zusammensetzung deren Parameter in den oben angegebenen Grenzen liegt, weist sehr gute piezoelektrische Eigenschaften auf.

Es konnten d₃₃-Werte von 400 bis 600 pm/V erreicht werden.

Die guten piezoelektrischen Eigenschaften können hierbei erzielt werden, ohne dass ein Einschluss von Fremdionen erfolgt, oder dass das Keramikmaterial auf sehr hohe Temperaturen erhitzt werden musste.

In einer weiteren Ausführungsform steht M für Nd.

Für das so gewählte M konnten besonders gute piezoelektrische Eigenschaften erzielt werden.

In einer weiteren Ausführungsform steht M für La.

Für das so gewählte M konnten ebenfalls besonders gute piezoelektrische Eigenschaften erzielt werden.

In einer weiteren Ausführungsform ist der Parameter a größer als der Parameter z. In diesem Fall liegt ein zweiphasiges System vor.

In einer weiteren Referenz-Ausführungsform des Keramikmaterials entspricht der Parameter a dem Parameter z, das bedeutet a = z. Somit ergibt die Formel: Pb_{1-(m/2)x}M^{m}ₓ(Zr_{1-y}Ti_{y})O₃.

Bei dieser Referenz-Ausführungsform liegt ein einphasiges System vor, welches besonders gute piezoelektrische Eigenschaften aufweist.

In einer weiteren Ausführungsform gilt für den Parameter x: 0,02 ≤ x ≤ 0,03.

Für den M-Anteil in dem angegebenen Bereich konnten besonders gute piezoelektrische Eigenschaften erzielt werden.

Es konnten d₃₃-Werte von 600 bis 800 pm/V erreicht werden.

In einer weiteren Ausführungsform gilt für den Parameter z: 0,01 ≤ z ≤ 0,1.

Für den so gewählten Parameter z konnten besonders gute piezoelektrische Eigenschaften erzielt werden.

In einer weiteren Referenz-Ausführungsform gilt für die Parameter z und a: 0 ≤ (a-z) < 0,01.

Für die so gewählten Parameter a und z konnten besonders gute piezoelektrische Eigenschaften erzielt werden.

In einer weiteren Ausführungsform gilt für die Parameter z und a: 0 < (a-z) < 0,01.

In einer weiteren Ausführungsform des Keramikmaterials weist dieses eine mittlere Korngröße im Bereich von 1 µm bis 3 µm auf.

Die Korngröße kann hierbei anhand von mikroskopischen Aufnahmen, wie beispielsweise einem Rasterelektronenmikroskop, von einem Schliff bestimmt werden.

Es hat sich in Versuchen gezeigt, dass der physikalische Parameter der mittleren Korngröße einen starken Einfluss auf die piezoelektrischen Eigenschaften des Keramikmaterials hat. Somit ist es erstrebenswert, ein Keramikmaterial zu erhalten, welches eine mittlere Korngröße aufweist, die in dem gewünschten Bereich liegt.

In einer weiteren Ausführungsform des Keramikmaterials weist dieses eine Dichte im Bereich von 7,6 bis 8,1 g/cm³ auf.

Für ein Keramikmaterial dieser Dichte konnten gute piezoelektrische Eigenschaften erzielt werden.

Bevorzugt ist hierbei ein Bereich von 7,8 bis 7,9 g/cm³. Für diesen Unterbereich konnten besonders gute piezoelektrische Eigenschaften erreicht werden.

In einem weiteren Ausführungsbeispiel des Keramikmaterials umfasst dieses keine zusätzlichen Sinterhilfsmittel.

Unter "keine zusätzlichen Sinterhilfsmittel" ist zu verstehen, dass abgesehen von dem PbTiO₃-Anteil der mit a-zPbTiO₃ bezeichnet wird, das Keramikmaterial keine weiteren Sinterhilfsmittel umfasst. Somit ist das Keramikmaterial frei von störenden Fremdionen, welche entweder in das Kristallgitter eingebaut werden würden, oder als weitere Phasen im Keramikmaterial vorliegen würden. Solche Fremdionen würden sich negativ auf die piezoelektrischen Eigenschaften des Keramikmaterials auswirken. Durch den Zusatz von PbTiO₃ das auch in das PZT-Gitter eingebaut werden kann wird der Sintervorgang, beispielsweise das Kornwachstum, positiv beeinflusst, ohne dass Ionen zugesetzt werden würden, welche nicht schon von sich aus in Keramikmaterial vorhanden sind.

Ein wie zuvor beschriebenes Keramikmaterial kann beispielsweise für Vielschichtbauelemente, wie einen piezoelektrischen Akuator verwendet werden.

Neben dem Keramikmaterial selbst wird auch ein Verfahren zur Herstellung des Keramikmaterials beansprucht.

In einer Variante des Verfahrens zur Herstellung eines Keramikmaterials umfasst dieses die Verfahrensschritte: Bereitstellen der Ausgangsstoffe umfassend Pb zu einem stöchiometrischen Anteil von 1-(m/2)x-z, M zu einem stöchiometrischen Anteil von x, Zr zu einem stöchiometrischen Anteil von 1-y und Ti zu einem stöchiometrischen Anteil von y-z als Verfahrensschritt A), Mischen und Vormahlen der Ausgangsstoffe als Verfahrensschritt B), Kalzinieren des Gemisches aus B) als Verfahrensschritt C), Zugabe von PbTiO₃ zu einem stöchiometrischen Anteil von a als Verfahrensschritt D), Mischen und Nachmahlen des Gemisches aus D) als Verfahrensschritt E) und Sintern des Gemisches aus E), zu einem Keramikmaterial, gemäß der allgemeinen Formel:

Pb_{1-(m/2)x}M^{m}ₓ(Zr_{1-y}Ti_{y})O₃ + a-zPbTiO₃

wobei M für ein Element steht ausgewählt aus: Nd, La, Ba, Sr, Sb, Bi, K, Na, und wobei gilt: 0 ≤ x ≤ 0,1; 0,3 ≤ y ≤ 0,7; 0,01 ≤ z ≤ 0,1; 0 ≤ (a-z) ≤ 0,03 und m entsprechend der Wertigkeit des jeweiligen Metalls M den Wert +1, +2 oder +3 hat als Verfahrensschritt F).

Hierbei werden im Verfahrensschritt A) die beiden Elemente Pb und Ti gezielt in einer stöchiometrischen Menge vorgelegt, welche um den Anteil z unter der Menge liegt, in der diese beiden Elemente im fertigen Keramikmaterial vorliegen sollen. Die anderen beiden Elemente M und Zr hingegen werden in jener stöchiometrischen Menge vorgelegt, in der sie dann auch im fertigen Keramikmaterial vorliegen sollen.

Im darauf folgenden Verfahrensschritt B) werden die Ausgangsstoffe gemischt und vorgemahlen. Das Mahlen kann beispielsweise mit einer Rührwerkskugelmühle, welche Zirkonoxidmahlkugeln umfasst, erfolgen. Das Vormahlen kann beispielsweise auf eine Teilchengröße von 1 µm erfolgen.

Die vorgemahlenen Ausgangsstoffe werden im darauf folgenden Verfahrensschritt C) kalziniert.

Erst nach dem Kalzinieren erfolgt dann im Verfahrensschritt D) die Zugabe von PbTiO₃ zu einem stöchiometrischen Anteil von a. Hierbei gilt für den Parameter a, dass er mindestens genauso groß ist wie der Parameter z. Somit werden die zuvor in einem unterstöchiometrischen Maße zugesetzten Elemente Pb und Ti durch die im Verfahrensschritt D) erfolgende Zugabe von PbTiO₃ auf ein stöchiometrisches Verhältnis gebracht, das sie im fertigen Keramikmaterial aufweisen werden. Dadurch dass das PbTiO₃ erst nach dem Kalzinieren zugegeben wird, bleibt es für den anschließenden Sintervorgang erhalten und reagiert nicht bereits beim Kalzinieren mit der PZT-Keramik.

Dies hat den Vorteil, dass der Anteil a an PbTiO₃ vor dem Sinterschritt noch als solches vorliegt. Das PbTiO₃ fördert während des Sinterverfahrensschrittes das Kornwachstum. Hierdurch kann durch die Zugabe des PbTiO₃ zu einem ausgewählten, genau bestimmten Anteil das Kornwachstum gezielt gesteuert werden.

Dies hat den Vorteil, dass nicht wie bei anderen Sinterhilfsmitteln Fremdionen zugesetzt werden, welche anschließend mit in das Keramikmaterial eingebaut werden, und t sich nachteilig auf die piezoelektrischen Eigenschaften des Keramikmaterials auswirken. Ein weiterer Vorteil ist, dass das Keramikmaterial nicht bei so hohen Temperaturen gesintert werden muss wie es der Fall wäre, wenn man für das Keramikmaterial eine entsprechende Korngröße erreichen möchte, ohne dass das PbTiO₃ nach dem Kalzinieren zugesetzt wird. So kann beispielsweise das Keramikmaterial der Zusammensetzung
Pb_{1-(m/2)x}M^{m}ₓ(Zr_{1-y}Ti_{y})O₃ + a-zPbTiO₃
bereits bei einer Temperatur von 1070 °C gesintert werden, wohingegen das entsprechende Keramikmaterial bei dem kein Zusatz von PbTiO₃ nach dem Kalzinieren erfolgt. Eine Sintertemperatur von 1120 °C benötigen würde um ein entsprechendes Kornwachstum zu erreichen.

Das Herabsetzen der Sintertemperatur hat des Weiteren den Vorteil, dass günstigere Materialien für beispielsweise Innenelektroden, welche mit dem Keramikmaterial gesintert werden, verwendet werden können. Somit kann beispielsweise der Pd-Anteil von einer Pd-Ag-Legierung von 30 Prozent auf 20 Prozent reduziert werden. Die Innenelektroden können aber auch eine Cu-Legierung umfassen, oder aus reinem Cu bestehen.

Nach der Zugabe des PdTiO₃ im Verfahrensschritt D) erfolgt ein erneutes Mischen und ein Nachmahlen des Gemisches im Verfahrensschritt E). Für das Mahlen kann wiederum eine Rührwerkskugelmühle mit Zirkonoxidmahlkugeln verwendet werden. Die Keramikteilchen werden nur diesmal vorzugsweise auf eine Größe von etwa 0,5 µm gemahlen.

Im nachfolgenden Sinterschritt F) wird das Gemisch dann zu einem Keramikmaterial gemäß der allgemeinen Formeln: Pb_{1-(m/2)x}M^{m}ₓ(Zr_{1-y}Ti_{y})O₃ + a-zPbTiO₃, wobei M für ein Element steht ausgewählt aus: Nd, La, Ba, Sr, Sb, Bi, K, Na, und wobei gilt: 0 ≤ x ≤ 0,1; 0,3 ≤ y ≤ 0,7; 0,01 ≤ z ≤ 0,1; 0 ≤ (a-z) ≤ 0,03 und m entsprechend der Wertigkeit des jeweiligen Metalls M den Wert +1, +2 oder +3 hat gesintert. Das so erhaltene Keramikmaterial weist sehr gute piezoelektrische Eigenschaften auf, ohne dass es auf sehr hohe Temperaturen erhitzt werden musste, oder dass Sinterhilfsmittel zugesetzt werden mussten, welche Fremdionen umfassen.

In einer weiteren Variante des Verfahrens werden zwischen den Verfahrensschritten E) und F) als weiterer Verfahrensschritt E1) Formteilen ausgeformt. Hierbei kann es sich beispielsweise um das Ausformen von Grünfolien handeln, welche beispielsweise in einem weiteren zusätzlichen Verfahrensschritt vor oder nach dem Sintern zu einem Vielschichtbauelement gestapelt werden können.

Zum Ausformen der Grünfolien kann dem Keramikmaterial beispielsweise ein Binder zugesetzt werden. Vorteilhaft ist hierbei ein Binder, welcher thermisch abbaubar ist.

Für die Innenelektroden des Vielschichtbauelements kann ein niedrig schmelzendes Metall, wie beispielsweise Cu, verwendet werden. Aufgrund der erniedrigten Sintertemperatur ist es jetzt möglich Vielschichtbauelemente zusammen mit ihren Innenelektroden zu sintern, auch wenn die Innenelektroden aus einem niedrig schmelzenden Metall gefertigt sind.

Das Vielschichtbauelement kann beispielsweise unter Luftatmosphäre gesintert werden, aber auch unter einer N₂-Atmosphäre, der H₂ zugesetzt wird und der Sauerstoffpartialdruck unter Zudosierung von Wasserdampf kontrolliert wird. Durch die Kontrolle des Sauerstoffpartialdrucks kann beispielsweise die Oxidation der Innenelektroden vermieden werden.

Der Binder in den Grünfolien kann vor dem Sinterschritt in einem weiteren Verfahrensschritt entfernt werden. Hierzu können ebenfalls die beiden oben genannten Atmosphären Anwendung finden.

In einer weiteren Variante des Verfahrens gilt: a = z. Somit liegt nach dem Sintern ein Keramikmaterial gemäß der allgemeinen Formel Pb_{1-(m/2)x}M^{m}ₓ(Zr_{1-y}Ti_{y})O₃ vor.

Bei dieser Variante wird im Verfahrensschritt D) der stöchiometrische Anteil des PbTiO₃ genau so gewählt, dass er der Menge entspricht, in denen die Elemente Pb und Ti im Verfahrensschritt A) unterstöchiometrisch eingesetzt wurden. Das bedeutet, dass die im Verfahrensschritt D) zugesetzten Pb- und Ti-Ionen vollständig auf die Gitterplätze des Pb_{1-(m/2)x}M^{m}ₓ(Zr_{1-y}Ti_{y})O₃ eingebaut werden können. Somit resultiert nach dem Sinterschritt F) ein einphasiges, homogenes Keramikmaterial. Dieses weist für die in den jeweils angegebenen Bereichen liegenden Parameter sehr gute piezoelektrische Eigenschaften auf.

Die mittlere Korngröße des fertigen Keramikmaterials wird durch die Zugabe des PbTiO₃ im Verfahrensschritt D) erhöht.

Da wie bereits zuvor ausgeführt das Kornwachstum bzw. die Korngröße in direktem Zusammenhang mit den piezoelektrischen Eigenschaften des Keramikmaterials steht, werden in diesem Verfahren die Korngröße bzw. die piezoelektrischen Eigenschaften des Materials durch die Zugabe des PbTiO₃ im Verfahrensschritt D) gesteuert. Bei herkömmlichen Prozessen wird das Kornwachstum in der Regel entweder durch die Zugabe von Sinterhilfsmitteln, welche Fremdionen enthalten, oder ausschließlich über die Sintertemperatur gesteuert.

In einer weiteren Variante des Verfahrens gilt für den Parameter z und a: 0 ≤ (a-z) < 0,01.

Für die so gewählten Parameter konnten Keramikmaterialien erzielt werden, welche besonders gute piezoelektrische Eigenschaften aufweisen.

In einer weiteren Variante des Verfahrens werden die Ausgangsstoffe im Verfahrensschritt A) als Oxide bereitgestellt.

Somit werden beispielsweise die Elemente Zr und Ti jeweils unabhängig voneinander als Oxid ZrO₂ und TiO₂ vorgelegt.

In einer weiteren Variante des Verfahrens werden die Ausgangsstoffe Zr und Ti im Verfahrensschritt A) als Precursor in Form von Zirkonium-Titan-Oxid (ZTO) oder Zirkonium-Titan-Hydrat (ZTH) bereitgestellt.

Durch den Einsatz des Precursors kann der Umsatz beim Kalzinieren bei niedrigeren Temperaturen erfolgen. Des Weiteren kann die Bildung von PbTiO₃ minimiert bzw. ausgeschlossen werden. Die vor dem Sinterschritt vorliegende Menge an PbTiO₃ soll möglichst exakt der Menge entsprechen, wie sie im Verfahrensschritt D) zugesetzt wird. Somit ist es möglich das Kornwachstum gezielt zu fördern.

In einer weiteren Variante des Verfahrens wird das Gemisch im Verfahrensschritt C) bei einer Temperatur von 850 °C bis 950 °C kalziniert.

In einer weiteren Variante, bei der der oben beschriebene Precursor verwendet wird, wird das Gemisch im Verfahrensschritt C) bei einer Temperatur von 600 °C bis 800 °C kalziniert.

Das Kalzinieren kann beispielsweise unter Luftatmosphäre über einen Zeitraum von 10 bis 20 Stunden erfolgen. Die Haltezeit bei der Maximaltemperatur kann hierbei beispielsweise 4 Stunden betragen.

In einer weiteren Variante des Verfahrens wird das Gemisch im Verfahrensschritt F) bei einer Temperatur von 900 °C bis 1200 °C gesintert.

Das Sintern kann beispielsweise unter Luftatmosphäre über einen Zeitraum von 24 Stunden erfolgen. Die Haltezeit bei der Maximaltemperatur kann hierbei beispielsweise 4 Stunden betragen.

Im Folgenden soll anhand eines Ausführungsbeispiels eines Bauelements ein möglicher Einsatzbereich für das piezoelektrische Keramikmaterial aufgezeigt werden.

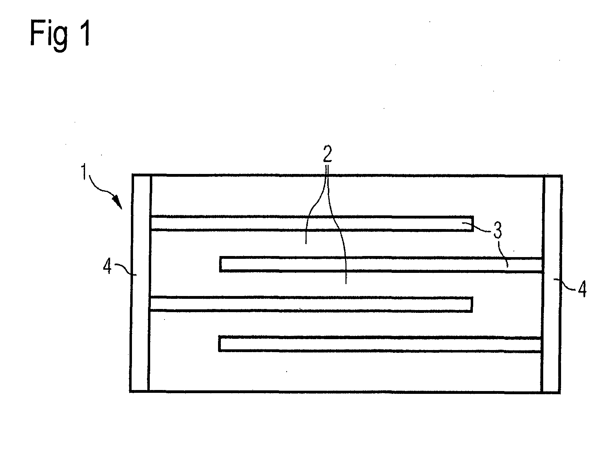

Figur 1: Schematische Seitenansicht eines piezoelektrischen Aktuators.

Die Figur 1 zeigt eine schematische Seitenansicht einer möglichen Ausführungsform, für ein Bauelement, für das das Keramikmaterial verwendet werden kann. In der Figur 1 ist ein piezoelektrischer Aktuator 1 in einer schematischen Seitenansicht dargestellt. Der piezoelektrische Aktuator 1 umfasst hierbei Keramikschichten 2 zwischen denen Innenelektroden 3 angeordnet sind. Die Innenelektroden 3 sind hierbei jeweils alternierend mit einer der beiden Außenelektroden 4 elektrisch leitend verbunden. Die Keramikschichten 2 umfassen hierbei ein Keramikmaterial, wie es zuvor beschrieben wurde. Ein piezoelektrische Aktuator 1 wie in der Figur dargestellt kann beispielsweise durch ein Verfahren hergestellt werden, in dem keramische Grünfolien alternierend mit Innenelektroden geschichtet werden. Diese Grünfolien können in einem vorgelagerten Verfahrensschritt beispielsweise durch das Versetzen des Keramikmaterials mit einem Binder geformt werden. Der Schichtenstapel aus den Innenelektroden 3 und den Keramikschichten 2 kann dann beispielsweise in einem gemeinsamen Sinterprozess gesintert werden. Hierbei ist es vorteilhaft, die Sintertemperatur möglichst gering zu halten, da somit für die Innenelektroden 3 ein Material verwendet werden kann, welches einen niedrigeren Schmelzpunkt aufweist, wie die sehr teuren Edelmetalle wie beispielsweise Pd. Es kann beispielsweise Cu in Form einer Legierung oder auch reines Cu für die Innenelektroden verwendet werden. Alternativ kann aber auch eine Pd-Ag-Legierung verwendet werden, welche eine Zusammensetzung von Pd/Ag zu den Anteilen 20/80 aufweist. Nach dem Sintern des Schichtenstapels kann dieser in einem weiteren Verfahrensschritt noch mit den Außenelektroden 4 versehen werden. Hierbei ist es wünschenswert, dass trotz der niedrigen Sintertemperatur das Keramikmaterial sehr gute piezoelektrische Eigenschaften aufweist, da von diesen die Leistungsfähigkeit des Bauelements abhängt.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Ausführungsbeispielen angegeben ist.

### Bezugszeichenliste

- 1: piezoelektrischer Aktuator
- 2: Keramikschicht
- 3: Innenelektrode
- 4: Außenelektrode

## Patentansprüche

1. Keramikmaterial, gemäß der allgemeinen Formel:
Pb_{1-(m/2)x}M^{m}ₓ(Zr_{1-y}Ti_{y})O₃ + a-zPbTiO₃
wobei M für mindestens ein Element steht ausgewählt aus: Nd, La, Ba, Sr, Sb, Bi, K, Na, und
wobei gilt: 0 ≤ x ≤ 0,1; 0,3 ≤ y ≤ 0,7; 0 ≤ z ≤ y; 0 < (a-z) ≤ 0,03
und m entsprechend der Wertigkeit des jeweiligen Metalls M den Wert +1, +2 oder +3 hat.

2. Keramikmaterial nach Anspruch 1,
wobei gilt: 0,02 ≤ x ≤ 0,03.

3. Keramikmaterial nach einem der Ansprüche 1 oder 2,
wobei die mittlere Korngröße des Keramikmaterials im Bereich von 1 µm bis 3 µm liegt.

4. Keramikmaterial nach einem der Ansprüche 1 bis 3,
wobei das Keramikmaterial eine Dichte im Bereich von 7,6 bis 8,1 g/cm³ aufweist.

5. Keramikmaterial nach einem der Ansprüche 1 bis 4,
wobei das Keramikmaterial keine zusätzlichen Sinterhilfsmittel umfasst.

6. Verfahren zur Herstellung eines Keramikmaterials, umfassend die Verfahrensschritte:
A) Bereitstellen der Ausgangsstoffe umfassend Pb zu einem stöchiometrischen Anteil von 1-(m/2)x-z, M zu einem stöchiometrischen Anteil von x, Zr zu einem stöchiometrischen Anteil von 1-y und Ti zu einem stöchiometrischen Anteil von y-z,
B) Mischen und Vormahlen der Ausgangsstoffe,
C) Kalzinieren des Gemisches aus B),
D) Zugabe von PbTiO₃ zu einem stöchiometrischen Anteil von a,
E) Mischen und Nachmahlen des Gemisches aus D),
F) Sintern des Gemisches aus E), zu einem Keramikmaterial, gemäß der allgemeinen Formel:
Pb_{1-(m/2)x}M^{m}ₓ(Zr_{1-y}Ti_{y})O₃ + a-zPbTiO₃
wobei M für ein Element steht ausgewählt aus: Nd, La, Ba, Sr, Sb, Bi, K, Na, und wobei gilt: 0 ≤ x ≤ 0,1; 0,3 ≤ y ≤ 0,7; 0,01 ≤ z ≤ 0,1; 0 ≤ (a-z) ≤ 0,03 und m entsprechend der Wertigkeit des jeweiligen Metalls M den Wert +1, +2 oder +3 hat.

7. Verfahren nach Anspruch 6,
zusätzlich umfassend den Verfahrenschritt zwischen den Verfahrensschritten E) und F):
E1) Ausformen von Formteilen.

8. Verfahren nach einem der Ansprüche 6 oder 7,
wobei gilt a = z, so dass nach dem Sintern ein Keramikmaterial gemäß der allgemeinen Formel:
Pb_{1- (m/2)x}M^{m}ₓ (Zr_{1-y}Ti_{y}) O₃
vorliegt.

9. Verfahren nach einem der Ansprüche 6 bis 8,
wobei die mittlere Korngröße des fertigen Keramikmaterials über die Zugabe des PbTiO₃ im Verfahrensschritt D) erhöht wird.

10. Verfahren nach einem der Ansprüche 6 bis 9,
wobei gilt: 0 ≤ (a-z) < 0,01.

11. Verfahren nach einem der Ansprüche 6 bis 10,
wobei die Ausgangsstoffe im Verfahrensschritt A) als Oxide bereitgestellt werden.

12. Verfahren nach einem der Ansprüche 6 bis 10,
wobei die Ausgangsstoffe Zr und Ti im Verfahrensschritt A) als Precursor in Form von Zirkonium-Titan-Oxid (ZTO) oder Zirkonium-Titan-Hydrat (ZTH) bereitgestellt werden.

13. Verfahren nach einem der Ansprüche 6 bis 12,
wobei das Gemisch im Verfahrensschritt C) bei einer Temperatur von 600 °C bis 950 °C kalziniert wird.

14. Verfahren nach einem der Ansprüche 6 bis 13,
wobei das Gemisch im Verfahrensschritt F) bei einer Temperatur von 900 °C bis 1200 °C gesintert wird.

## Claims

1. Ceramic material of the general formula:
Pb_{1-(m/2)x}M^{m}ₓ(Zr_{1-y}Ti_{y})O₃ + a-zPbTiO₃,
where M is at least one element selected from: Nd, La, Ba, Sr, Sb, Bi, K, Na, and
where: 0 ≤ x ≤ 0.1; 0.3 ≤ y ≤ 0.7; 0 ≤ z ≤ y; 0 < (a-z) ≤ 0.03,
and m, corresponding to the valency of the respective metal M, has the value +1, +2 or +3.

2. Ceramic material according to Claim 1,
where: 0.02 ≤ x ≤ 0.03.

3. Ceramic material according to either of Claims 1 and 2,
wherein the mean grain size of the ceramic material is in the range of 1 µm to 3 µm.

4. Ceramic material according to one of Claims 1 to 3,
wherein the ceramic material has a density in the range of 7.6 to 8.1 g/cm³.

5. Ceramic material according to one of Claims 1 to 4,
wherein the ceramic material comprises no additional sintering aids.

6. Process for producing a ceramic material,
comprising the following process steps:
A) providing the starting substances comprising Pb to a stoichiometric proportion of 1-(m/2)x-z, M to a stoichiometric proportion of x, Zr to a stoichiometric proportion of 1-y and Ti to a stoichiometric proportion of y-z,
B) mixing and pre-milling the starting substances,
C) calcining the mixture from B),
D) adding PbTiO₃ to a stoichiometric proportion of a,
E) mixing and subsequently milling the mixture from D),
F) sintering the mixture from E) to give a ceramic material of the general formula:
Pb_{1-(m/2)x}M^{m}ₓ(Zr_{1-y}Ti_{y})O₃ + a-zPbTiO₃,
where M is an element selected from: Nd, La, Ba, Sr, Sb, Bi, K, Na, and where: 0 ≤ x ≤ 0.1; 0.3 ≤ y ≤ 0.7; 0.01 ≤ z ≤ 0.1; 0 ≤ (a-z) ≤ 0.03, and m, corresponding to the valency of the respective metal M, has the value +1, +2 or +3.

7. Process according to Claim 6,
additionally comprising the following process step between process steps E) and F):
E1) forming shaped parts.

8. Process according to either of Claims 6 and 7, where a = z, such that a ceramic material of the following general formula is present after the sintering:
Pb_{1-(m/2)x}M^{m}ₓ(Zr_{1-y}Ti_{y}) 03.

9. Process according to one of Claims 6 to 8,
wherein the mean grain size of the finished ceramic material is increased by the addition of the PbTiO₃ in process step D).

10. Process according to one of Claims 6 to 9,
where: 0 ≤ (a-z) < 0.01.

11. Process according to one of Claims 6 to 10,
wherein the starting substances are provided as oxides in process step A).

12. Process according to one of Claims 6 to 10,
wherein the starting substances Zr and Ti are provided as precursors in the form of zirconium-titanium oxide (ZTO) or zirconium-titanium hydrate (ZTH) in process step A).

13. Process according to one of Claims 6 to 12,
wherein the mixture is calcined at a temperature of 600°C to 950°C in process step C).

14. Process according to one of Claims 6 to 13,
wherein the mixture is sintered at a temperature of 900°C to 1200°C in process step F).

## Revendications

1. Matériau céramique selon la formule générale :
Pb_{1-(m/2)x}M^{m}ₓ(Zr_{1-y}Ti_{y})O₃ + a-zPbTiO₃
M représentant au moins un élément choisi parmi : Nd, La, Ba, Sr, Sb, Bi, K, Na, et où : 0 ≤ x 0,1 ; 0,3 ≤ y ≤ 0,7 ; 0 ≤ z ≤ y ; 0 < (a-z) ≤ 0,03 et m, en fonction de la valence du métal M en question, présentant la valeur +1, +2 ou +3.

2. Matériau céramique selon la revendication 1, où : 0,02 ≤ x ≤ 0,03.

3. Matériau céramique selon l'une quelconque des revendications 1 ou 2, la grosseur moyenne de particule du matériau céramique se situant dans la plage de 1 µm à 3 µm.

4. Matériau céramique selon l'une quelconque des revendications 1 à 3, le matériau céramique présentant une densité dans la plage de 7,6 à 8,1 g/cm³.

5. Matériau céramique selon l'une quelconque des revendications 1 à 4, le matériau céramique ne comprenant pas d'adjuvant de frittage supplémentaire.

6. Procédé pour la préparation d'un matériau céramique, comprenant les étapes de procédé :
A) mise à disposition des substances de départ comprenant Pb à raison d'une proportion stoechiométrique de 1-(m/2)x-z, M à raison d'une proportion stoechiométrique de x, Zr à raison d'une proportion stoechiométrique de 1-y et Ti à raison d'une proportion stoechiométrique de y-z,
B) mélange et prébroyage des substances de départ,
C) calcination du mélange provenant de B),
D) addition de PbTiO₃ à raison d'une proportion stoechiométrique de a,
E) mélange et post-broyage du mélange provenant de D),
F) frittage du mélange provenant de E) en un matériau céramique selon la formule générale :
Pb_{1-(m/2)x}M^{m}ₓ(Zr_{1-y}Ti_{y})O₃ + a-zPbTiO₃
M représentant un élément choisi parmi : Nd, La, Ba, Sr, Sb, Bi, K, Na, et où : 0 ≤ x 0,1 ; 0,3 ≤ y ≤ 0,7 ; 0,01 ≤ z ≤ 0,1 ; 0 ≤ (a-z) ≤ 0,03 et m, en fonction de la valence du métal M en question, présentant la valeur +1, +2 ou +3.

7. Procédé selon la revendication 6, comprenant en outre l'étape de procédé entre les étapes de procédé E) et F) :
E1) moulage de pièces moulées.

8. Procédé selon l'une quelconque des revendications 6 ou 7, dans lequel a = z, de manière telle qu'on obtient après le frittage un matériau céramique selon la formule générale :
Pb_{1-(m/2)x}M^{m}ₓ (Zr_{1-y}Ti_{y}) O₃.

9. Procédé selon l'une quelconque des revendications 6 à 8, la grosseur moyenne de particule du matériau céramique fini étant augmentée via l'addition du PbTiO₃ dans l'étape de procédé D).

10. Procédé selon l'une quelconque des revendications 6 à 9, où : 0 ≤ (a-z) < 0,01.

11. Procédé selon l'une quelconque des revendications 6 à 10, les substances de départ étant mises à disposition sous forme d'oxydes dans l'étape de procédé A).

12. Procédé selon l'une quelconque des revendications 6 à 10, les substances de départ Zr et Ti étant mises à disposition en tant que précurseur sous forme d'oxyde de zirconium-titane (ZTO) ou d'hydrate de zirconium-titane (ZTH).

13. Procédé selon l'une quelconque des revendications 6 à 12, le mélange dans l'étape de procédé C) étant calciné à une température de 600°C à 950°C.

14. Procédé selon l'une quelconque des revendications 6 à 13, le mélange dans l'étape de procédé F) étant fritté à une température de 900°C à 1200°C.
